# EUROPÄISCHE PATENTANMELDUNG

(11) **EP 1 480 505 A2**
(43) Veröffentlichungstag der Anmeldung: **24.11.2004**
(21) Anmeldenummer: 04009566.3
(22) Anmeldetag: 22.04.2004
(51) Int. Cl.: H05K 13/00

(54) **Bedientafel zur Bedienung von Werkzeug- oder Produktionsmaschinen**

(30) Priorität: 14.05.2003 DE 10321663
(71) Anmelder: SIEMENS AKTIENGESELLSCHAFT, 80333 München (DE)
(72) Erfinder: Adolf, Rainer, 91522 Ansbach (DE); Bunk, Jens-Andre, 96231 Staffelstein (DE); Moniac, Sven, 90579 Langenzenn (DE); Weigert, Franz-Josef, 90537 Feucht (DE)

(57) **Zusammenfassung**

Die Erfindung betrifft eine Bedientafel zur Bedienung von Werkzeug- oder Produktionsmaschinen wobei die Bedientafel ein an spezifische Kundenwünsche in der Form und Ausstattung anpassbare Folientastatur (1) aufweist, wobei die Bedientafel zur Befestigung der Folientastatur (1), eine an die Form und Ausstattung der Folientastatur (1) angepasste Frontplatte (4) sowie an die Außenkontur der Frontplatte (4) angepasste Rahmenprofile (2a,2b,2c,2d) zur Aufnahme der Frontplatte (4) aufweist. Die Erfindung ermöglicht somit eine Bedientafel, die mit nur geringem Aufwand an individuelle Kundenwünsche angepasst werden kann.

## Beschreibung

Die Erfindung bezieht sich auf eine Bedientafel zur Bedienung von Werkzeug- oder Produktionsmaschinen, wobei die Bedientafel eine an spezifische Kundenwünsche in der Form und Ausstattung anpassbare Folientastatur aufweist.

Derartige Bedientafeln zur Bedienung von Werkzeug- oder Produktionsmaschinen sind allgemein bekannt. Die Bedientafeln dienen hierbei zur Überwachung des Produktionsprozesses sowie z.B. zur Eingabe von Parametern oder zur bedienergeführten Steuerung der Werkzeug- oder Produktionsmaschine.

Handelsübliche Bedientafeln bestehen im Wesentlichen dabei aus einer Folientastatur und einer gehäusebildenden Kunststofffront zur Befestigung der Folientastatur.

Die Kunststofffront wurde dabei bisher werkzeuggebunden z.B. mit einer Kunststoffspritzgussmaschine in einer entsprechenden Spritzgussform hergestellt. Die Herstellung solcher Spritzgussformen ist sehr aufwändig und mit hohen Kosten verbunden. Neue Varianten von Bedientafelfronten mit einer an spezifische Kundenwünsche angepasster Form und Ausstattung sind somit für kleinere und mittlere Stückzahlen mit hohem Kosten- und Anpassungsaufwand verbunden. Für kleinere Stückzahlen sind somit hinsichtlich Form und Ausstattung insbesondere Design oft große Kompromisse notwendig. Weiterhin ist eine Lageveränderung der systembildenden Merkmale wie z.B. dem verwendeten Display, einer analogen Handeingabe oder einer frontseitig angebrachten Schnittstelle sind werkzeuggebundenen Kunststofffronten nur mit hohem Aufwand realisierbar. Der Aufwand für eine neue Produktvariante entspricht nahezu dem einer Neuentwicklung.

Der Erfindung liegt daher die Aufgabe zugrunde, eine Bedientafel, die mit nur geringem Aufwand an individuelle Kundenwünsche angepasst werden kann, zu schaffen.

Diese Aufgabe wird für eine Bedientafel der eingangs genannten Art dadurch gelöst, dass die Bedientafel zur Befestigung der Folientastatur, eine an die Form und Ausstattung der Folientastatur angepasste Frontplatte sowie an die Außenkontur der Frontplatte angepasste Rahmenprofile zur Aufnahme der Frontplatte aufweist.

Ferner wird mit Hilfe der erfindungsgemäßen Bedientafel ein schneller Produktentstehungsprozess ermöglicht.

Eine erste vorteilhafte Ausbildung der Erfindung ist dadurch gekennzeichnet, dass die Bedientafel als rückwandseitiger Gehäuseabschluss eine in der Form der Frontplatte angepasste Trägerplatte aufweist. Hierdurch ist ein sicherer Gehäuseabschluss sichergestellt.

Wenn die Frontplatte und/oder die Rahmenprofile und/oder die Trägerplatte der Bedientafel aus Metall bestehen, können diese besonders leicht gemäß der gewünschten Form und Ausstattung der Bedientafel hergestellt werden.

Ferner erweist es sich als vorteilhaft, wenn die Folientastatur und die Frontplatte einen oder mehrere Ausschnitte für einen Display und/oder eine analog bedienbare Handeingabe und/oder Kurzhubtasten und/oder eine Kommunikationsschnittstelle aufweist. Durch die individuelle Möglichkeit, Ausschnitte einfach, in beliebiger Form und nahezu beliebiger Anzahl für spezifische Bedienelemente oder Anzeigen in der Folientastatur und in der Frontplatte vorzusehen, kann die Bedientafel individuell auf Kundenwünsche adaptiert werden.

In diesem Zusammenhang erweist es sich als vorteilhaft, wenn als Kommunikationsschnittstelle eine USB-Schnittstelle, Fire-Wire-Schnittstelle, Ethernet-Schnittstelle oder eine Profi-Bus-Schnittstelle vorgesehen ist. Solche Schnittstellen sind in der Technik bekannte Standard-Schnittstellen.

Ferner erweist es sich als vorteilhaft, wenn die Bedientafel mit Hilfe eines Konfigurationsprogramms durch Auswahl von möglichen Konfigurationen vom Anwender vor Fertigung der Bedientafel planbar ist. Ein solches Konfigurationsprogramm ermöglicht dem Kunden bzw. dem Vertrieb/Marketing eine besonders einfache Möglichkeit, die Bedientafel vor ihrer Fertigung zu planen.

Weiterhin erweist es sich als vorteilhaft, wenn die Auswahl der möglichen Konfiguration vom Anwender mittels einer schrittweisen Auswahl und Darstellung der Konfiguration durchführbar ist. Hierdurch wird dem Anwender eine besonders einfache Auswahl der Konfiguration ermöglicht.

Ferner erweist es sich als vorteilhaft, wenn nach durchgeführter Konfiguration vom Konfigurationsprogramm eine Berechnung der Kosten und/oder des Preises der Bedientafel erfolgt. Dies ermöglicht dem Anwender, im Falle zu hoher Kosten und/oder eines zu hohen Preises sofort eine Änderung der Konfiguration durchzuführen.

Wenn nach durchgeführter Konfiguration vom Konfigurationsprogramm fertigungsrelevante Zeichnungen für die Bedientafel erstellbar sind, kann eine besonders geringe Produktentstehungszeit gewährleistet werden.

Ein Ausführungsbeispiel der Erfindung ist in der Zeichnung dargestellt und wird im Folgenden näher erläutert. Dabei zeigen:
- FIG 1: den Basisaufbau der Bedientafel,
- FIG 2: die Auswahl der Displaygröße mit dem Konfigurationsprogramms,
- FIG 3: die Auswahl der Anzahl und Lage der Softkeyfelder mit dem Konfigurationsprogramm,
- FIG 4: die Auswahl der Lage eines Tastaturblocks mit dem Konfigurationsprogramms und
- FIG 5: eine Auswahl der Minimalabmessung der Bedientafel sowie das Ergebnis der gewählten Konfiguration.

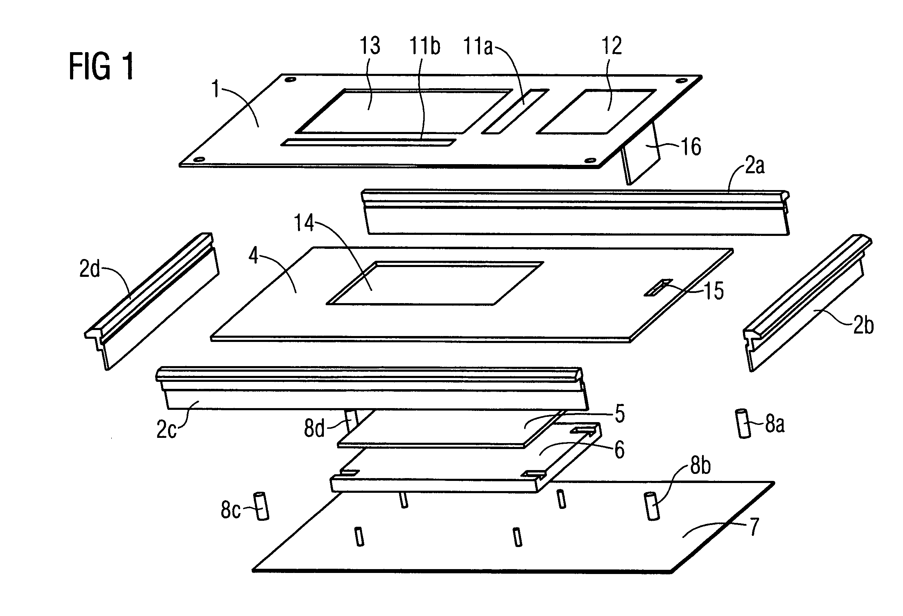

In FIG 1 ist in Form einer Explosionszeichnung der Basisaufbau der erfindungsgemäßen Bedientafel dargestellt. In FIG 1 ist dabei eine Folientastatur 1, welche an eine in Form und Ausstattung der Folientastatur 1 angepasste Frontplatte 4 befestigt wird, gezeigt. Vier an die Frontplatte 4 angepasste Rahmenprofile 2a, 2b, 2c und 2d, dienen zur Aufnahme der Frontplatte 4. In die Folientastatur 1 sind zwei Softkeyfelder 11a und 11b sowie ein Tastaturfeld 12 integriert. Weiterhin weist die Folientastatur 1 einen Ausschnitt 13 und die Frontplatte 4 einen Ausschnitt 14 für ein Display 6 auf. Zwischen Frontplatte 4 und Display 6 ist eine Glasscheibe 5 zum Schutz des Displays 6 montiert. Der rückwandseitige Gehäuseabschluss ist in Form einer der Frontplatte 4 angepassten Trägerplatte 7 realisiert. Mit Hilfe von Befestigungsbolzen 8a, 8b, 8c und 8d, wird die Frontplatte 4 mit der Trägerplatte 7 verbunden. Das Display 6 ist mit der Trägerplatte 7 über vier kleinere, in FIG 1 der Übersichtlichkeit halber nicht bezifferte Befestigungsbolzen, befestigt.

Bei handelsüblichen Bedientafeln von Werkzeug- oder Produktionsmaschinen sind die Rahmenprofile 2a, 2b, 2c, 2d und die Frontplatte 4 aus einem einzigen zusammenhängenden Kunststoffteil, der sogenannten Kunststofffront, gefertigt.

Heutzutage wird von Kundenseite an die Hersteller von Bedientafeln immer mehr die Anforderung gestellt, für eine Werkzeug- oder Produktionsmaschine kundenspezifische Bedientafeln zu liefern. So soll z.B. die Lage und Anzahl der Softkeyfelder, welche jeweils eine variable Anzahl von Softkeys aufweisen und der Tastaturfelder sowie Lage und Größe des Displays insbesondere die Höhe und Breite des Displays sowie die Form insbesondere die Höhe und Breite der Bedientafel individuell vom Kunden festlegbar sein.

Die Herstellung der Folientastatur gemäß den Vorgaben des Kunden stellt dabei im Allgemeinen kein Problem dar, da diese sehr kostengünstig an die Anforderung des Kunden adaptierbar ist. Eine ganz andere Ausgangslage ergibt sich jedoch für die Kunststofffront. Eine Veränderung der Form und Ausstattung der Folientastatur bedingt in den meisten Fällen eine notwendige Änderung der Kunststofffront. Dies hat zur Folge, dass nahezu für jede geänderte Folientastatur eine eigene Spritzgussform für die dazugehörige Kunststofffront hergestellt werden muss. Die Herstellung solcher Spritzgussformen ist wie schon gesagt aufwendig und teuer, so dass sich dieser Aufwand nur bei größeren Stückzahlen von Bedientafeln lohnt.

An dieser Stelle setzt nun die erfindungsgemäße Bedientafel ein. Anstatt der bekannten Kunststofffront wird die Folientastatur 1 in FIG 1 an einer aus Metall gefertigten Frontplatte 4 befestigt. Eine solche Frontplatte 4 kann leicht z.B. mittels Stanzen aus Metallblech auch in kleinen Stückzahlen kostengünstig hergestellt werden. Die an die Frontplatte 4 angepassten Rahmenprofile 2a, 2b, 2c und 2d können ebenfalls auch in kleineren Stückzahlen leicht aus Metallprofilen kostengünstig hergestellt werden. Hierzu müssen lediglich von einer langen Profilleiste die Rahmenprofile entsprechend der benötigten Länge und Breite der Frontplatte 4 bzw. der Folientastatur 1 zugeschnitten werden. Die sonst üblich verwendete Kunststofffront wird quasi somit durch ein Baukastensystem, dass sich aus den vier Rahmenprofilen 2a, 2b, 2c und 2d sowie einer Frontplatte 4 zusammensetzt, ersetzt. Das Baukastensystem ist quasi in Form eines Bilderrahmens realisiert. Somit ist auch eine kostengünstige Herstellung von Bedientafeln bei kleinen Stückzahlen möglich.

Neben dem Ausschnitt 13 kann die Folientastatur 1 selbstverständlich noch weitere Ausschnitte, z.B. für eine Kommunikationsschnittstelle oder eine analog bedienbare Handeingabe, aufweisen. Die Frontplatte 4 kann dann entsprechend mit hierzu korrespondierenden Ausschnitten gefertigt werden. In dem Ausführungsbeispiel weist die Frontplatte 4 einen zusätzlichen Ausschnitt 15 zum Durchführen eines Flachbandkabels 16 von der Folientastatur 1 auf.

Häufig ist vom Kunden auch eine spezielle Farbe der Kunststofffront gewünscht. Dies war bis jetzt ebenfalls nur mit Verwendung eines gefärbten Kunststoffes möglich. Bei der erfindungsgemäßen Bedientafel müssen hierfür lediglich die metallenen Rahmenprofile 2a, 2b, 2c und 2d in der gewünschten Farbe lackiert werden.

Entsprechend lässt sich auch leicht die Frontplatte 4 mit Beschriftungen für z.B. den USB-Anschluss oder einer analog bedienbaren Handeingabe realisieren.

Selbstverständlich können mit Hilfe eines weiteren Ausschnittes in der Folientastatur 1 und der Frontplatte 4 auch Kurzhubtasten eingebaut werden.

Durch entsprechend eingesetzte Dichtungen z.B. zwischen Frontplatte 4 und den Rahmenprofilen 2a, 2b, 2c und 2d kann die erfindungsgemäße Bedientafeln auch im Bereich hoher Wasserschutzklassen (z.B. IP 54, IP 65 und NEMA 4) verwendet werden.

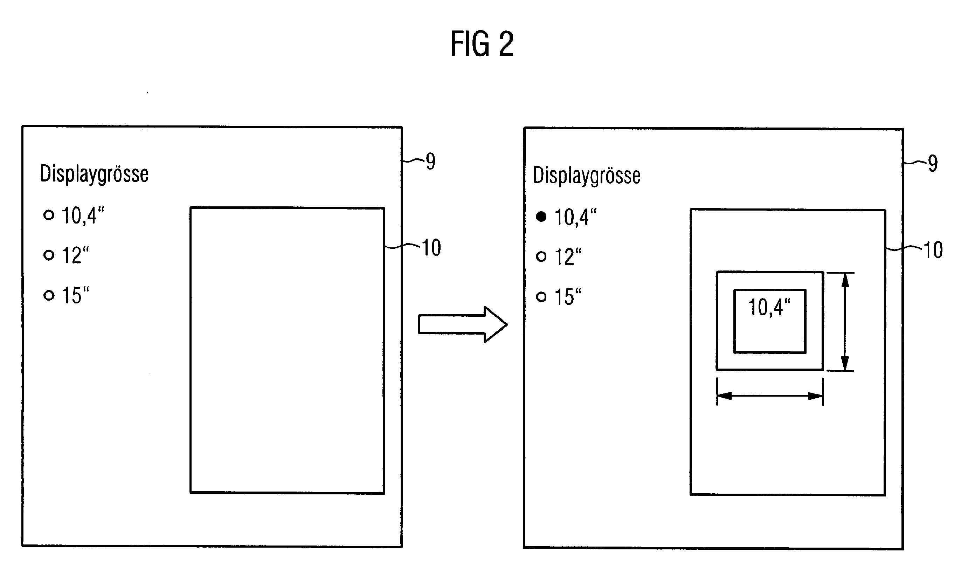

Weiterhin kann die erfindungsgemäße Bedientafel mit Hilfe eines Konfigurationsprogramms durch Auswahl von möglichen Konfigurationen vom Anwender vor Fertigung der Bedientafel geplant werden. In den Figuren 2 bis 5 sind beispielhaft jeweils zwei vom Konfigurationsprogramm auf einem Bildschirm erzeugte Bildschirmfenster 9 dargestellt. Das Konfigurationsprogramm kann dabei z.B. auf einem handelsüblichen Personal Computer oder Laptop oder ähnlichem gestartet werden. Zuerst muss der Anwender die Größe des Displays festlegen. Hierzu kann er in dem Ausführungsbeispiel die Displaygröße entweder zu 10,4 cm, 12 cm oder 15 cm Bildschirmdiagonale festlegen. Nach Auswahl der Displaygröße durch Anklicken der zu wählenden Displaygröße (im Ausführungsbeispiel wurde 10,4 cm Bildschirmdiagonale gewählt) erscheint in einem Vorschaufenster 10 der entsprechende Display mit den gewünschten Bemaßungen.

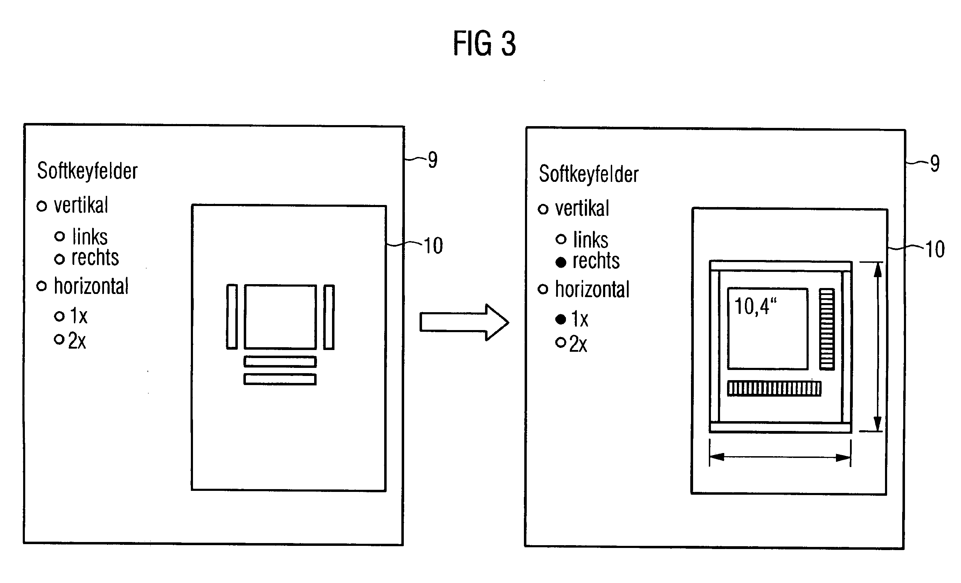

Anschließend wird gemäß FIG 3 vom Anwender die Lage und Anzahl der Softkeyfelder durch Anklicken festgelegt. Das Ergebnis wird wieder im Vorschaufenster 10 dargestellt.

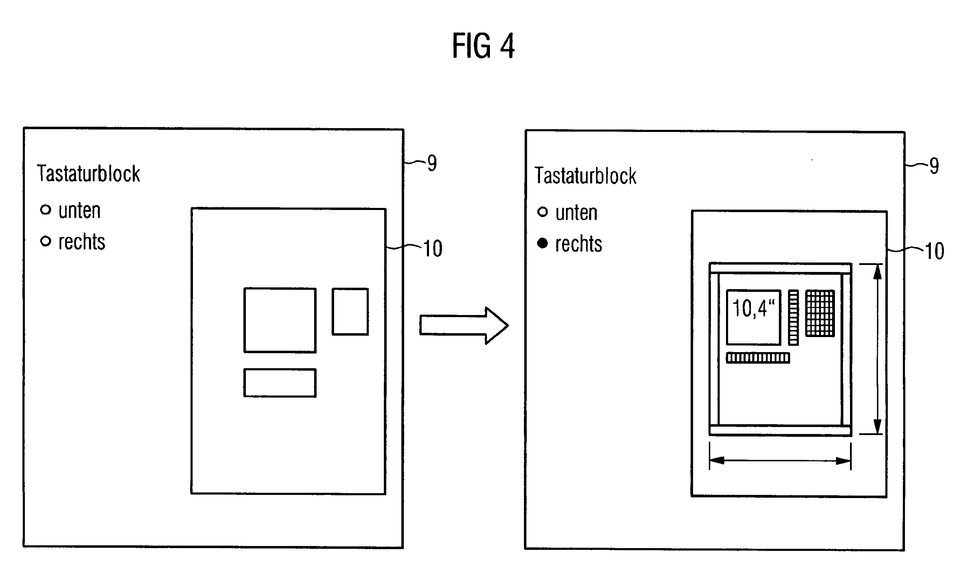

Dann erfolgt z.B., wie in FIG 4 dargestellt, die Auswahl der Lage des Tastaturfeldes auf dieselbe Art und Weise. Das Ergebnis wird wieder im Vorschaufenster 10 dargestellt.

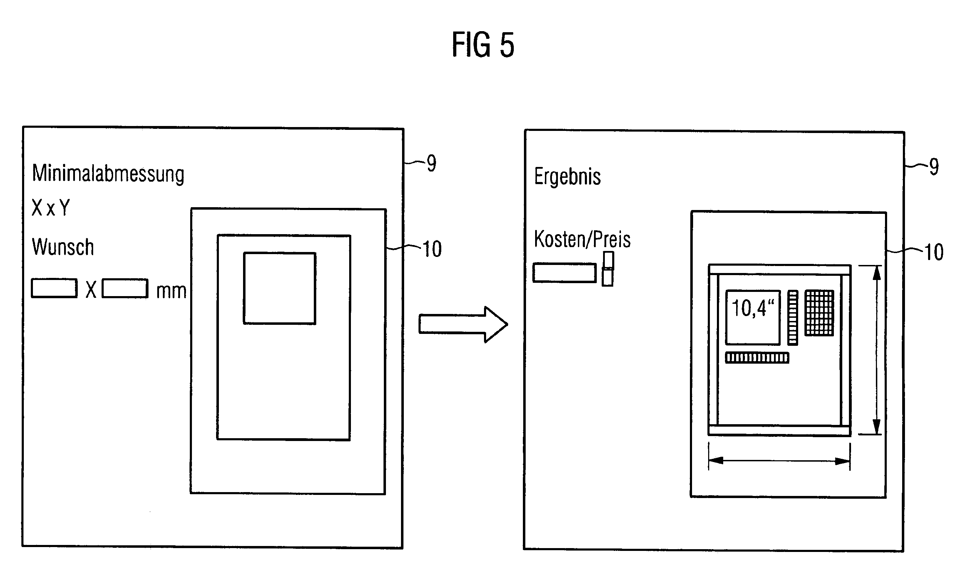

Zum Schluss werden dem Anwender die Minimalabmessungen der Bedientafel, wie in FIG 5 dargestellt, angezeigt. Diese kann er entsprechend seinen Wünschen ändern. Als Ergebnis wird dem Anwender im Vorschaufenster 10 eine Ansicht der gewählten Bedientafel dargestellt. Weiterhin wird ihm in einem anderen Feld die Kosten bzw. der Preis für die gewählte Ausführungsform der Bedientafel angezeigt.

Selbstverständlich können in der Realität noch wesentlich mehr konfigurierbare Parameter und Teile vorhanden sein bzw. realisiert werden. Die in den Figuren 2 bis 5 dargestellten Schritte stellen diesbezüglich nur eine Auswahl dar.

Ist der Anwender bzw. der Kunde mit dem Preis bzw. den Kosten für die Bedientafel einverstanden, so erstellt das Konfigurationsprogramm fertigungsrelevante Zeichnungen für die gewählte Konfiguration der Bedientafel.

Selbstverständlich muss die Frontplatte und die Rahmenprofile nicht unbedingt wie im Ausführungsbeispiel aus Metall gefertigt sein. Sie kann auch aus anderen Materialien bestehen. Metallausführungen lassen sich aber besonders leicht an die Folientastatur anpassen.

An dieser Stelle sei angemerkt, dass als Werkzeugmaschinen z.B. ein- oder mehrachsige Dreh-, Fräs-, Bohr- oder Schleifmaschinen zu verstehen sind. Zu den Werkzeugmaschinen werden auch noch Bearbeitungszentren, lineare und rotatorische Transfermaschinen, Lasermaschinen oder Wälz- und Verzahnmaschinen gezählt. Allen gemeinsam ist, dass ein Material bearbeitet wird, wobei diese Bearbeitung mehrachsig ausgeführt werden kann. Zu den Produktionsmaschinen werden z.B. Textil-, Kunststoff-, Holz-, Glas-, Keramik- oder Steinbearbeitungsmaschinen gezählt. Maschinen der Umformtechnik, Verpackungstechnik, Drucktechnik, Fördertechnik, Pumpentechnik, Lüftertechnik, Hebewerkzeuge sowie Roboter gehören ebenfalls zu den Produktionsmaschinen.

Weiterhin sei an dieser Stelle angemerkt, dass handelsüblich, neben den schon genannten Kunststofffronten auch Fronten aus Aluminiumguss existieren. Da Aluminiumgussfronten ebenfalls werkzeuggebunden mit einer entsprechenden teueren und aufwändig herzustellenden Gussform hergestellt werden, treten jedoch auch bei diesen Fronten die gleichen Probleme auf wie bei den Kunststofffronten.

## Patentansprüche

1. Bedientafel zur Bedienung von Werkzeug- oder Produktionsmaschinen wobei die Bedientafel ein an spezifische Kundenwünsche in der Form und Ausstattung anpassbare Folientastatur (1) aufweist, **dadurch gekennzeichnet, dass** die Bedientafel zur Befestigung der Folientastatur (1), eine an die Form und Ausstattung der Folientastatur (1) angepasste Frontplatte (4) sowie an die Außenkontur der Frontplatte (4) angepasste Rahmenprofile (2a,2b,2c,2d) zur Aufnahme der Frontplatte (4) aufweist.

2. Bedientafel nach Anspruch 1, **dadurch gekennzeichnet, dass** die Bedientafel als rückwandseitiger Gehäuseabschluss eine in der Form der Frontplatte (4) angepasste Trägerplatte (7) aufweist.

3. Bedientafel, nach einem der vorhergehenden Ansprüche, **dadurch gekennzeichnet, dass** die Frontplatte (4) und/oder die Rahmenprofile (2a,2b,2c,2d) und/oder die Trägerplatte (7) aus Metall besteht.

4. Bedientafel, nach einem der vorhergehenden Ansprüche, **dadurch gekennzeichnet, dass** die Folientastatur (1) und die Frontplatte (4) einen oder mehrere Ausschnitte (14,15) für einen Display (6) und/oder eine analog bedienbare Handeingabe und/oder Kurzhubtasten und/oder eine Kommunikationsschnittstelle aufweist.

5. Bedientafel, nach Anspruche 4, **dadurch gekennzeichnet, dass** als Kommunikationsschnittstelle eine USB-Schnittstelle, Fire-Wire-Schnittstelle, Ethernet-Schnittstelle oder eine Profi-Bus-Schnittstelle vorgesehen ist.

6. Bedientafel nach einem der vorhergehenden Ansprüche, **dadurch gekennzeichnet, dass** die Bedientafel mit Hilfe eines Konfigurationsprogramms durch Auswahl von möglichen Konfigurationen vom Anwender vor Fertigung der Bedientafel planbar ist.

7. Bedientafel, nach Anspruche 6, **dadurch gekennzeichnet, dass** die Auswahl der möglichen Konfigurationen vom Anwender mittels einer schrittweisen Auswahl und Darstellung der Konfiguration durchführbar ist.

8. Bedientafel, nach Anspruch 6 oder 7, **dadurch gekennzeichnet, dass** nach durchgeführter Konfiguration vom Konfigurationsprogramm eine Berechnung der Kosten und/oder des Preises der Bedientafel erfolgt.

9. Bedientafel, nach Anspruch 6, 7 oder 8, **dadurch gekennzeichnet, dass** nach durchgeführter Konfiguration vom Konfigurationsprogramm fertigungsrelevante Zeichnungen für die Bedientafel erstellbar sind.
